# EUROPEAN PATENT APPLICATION

(11) **EP 4 844 388 A1**
(43) Date of publication of application: **25.11.2026**
(21) Application number: 25382517.8
(22) Date of filing: 22.05.2025
(51) Int. Cl.: G01N 24/08, G01R 33/46

(54) **METHOD OF ANALYSIS FOR IDENTIFYING AND CLASSIFYING FERMENTED BEVERAGES**

(71) Applicant: Universidad de Sevilla, 41013 Sevilla (ES)
(72) Inventor: De la Rosa Acosta, Miguel Ángel, Sevilla (ES); Díaz Moreno, Irene, Sevilla (ES); Guerra Castellano, Alejandra, Sevilla (ES); Fernández Veloso, Andrea, Sevilla (ES); Hiniesta Valero, Jaime, Sevilla (ES)
(74) Representative: Pons IP

(57) **Abstract**

Method of analysis for identifying and classifying fermented beverages (1), comprising the steps of: i) preparing at least two independent samples (11) of each class (12) of the fermented beverages (1); ii) performing data acquisition with a Nuclear Magnetic Resonance spectrometer (2) over samples (11); iii) performing data processing over the Nuclear Magnetic Resonance data of the sample (11) comprising: an automated local spectra alignment, performed by checking and correcting chemical shift deviations of the sample (11); and data modelling performed by using a Discriminant Analysis variants of multidimensional supervised model for determining the class (12) of every sample (11); iv) generating a digital fingerprint (3) based on the classes (12) determined, for achieving a standardised protocol to identify and classify fermented beverages (1) and derivatives according to complex variables, as well to ensure quality control and fraud detection.

## Description

### TECHNICAL FIELD OF THE INVENTION

The technical field of the invention is directly related to the agri-food field, and the activity sector in which this invention is applicable is the industry of fermented beverages and their derivatives. Therefore, this includes beer, wine, vinegar, kombucha, cider, or sake industries, among others. Also is related to advancing food product certification, by means of a nondestructive Nuclear Magnetic Resonance and Artificial Intelligence-based digital fingerprint to identify fermented beverages and derivatives. The method of analysis for identifying and classifying fermented beverages comprises the steps of preparing sample of the fermented beverage, performing data acquisition, data processing, and generating a digital fingerprint, according to claims 1 to 15, incorporating notable innovations and advantages over technical solutions used so far.

### BACKGROUND OF THE INVENTION

Currently most of the consumed beverages worldwide are fermented beverages (FB), including those Low-Alcoholic and Non-Alcoholic Fermented Beverages (LAFB, and NAFB, respectively). As such, it is object of many research studies, projects, and inventions or patents, to characterize these beverages. However, in most cases, resources on research have mainly been focused on refining the different stages of the production, to improve or innovate products. Examples of this can be found on the Cooperative Patent Classification (CPC) of the European Patent Office (EPO) and the United States Patent and Trademark Office (USPTO), by the code C.12., in the class "Chemistry", which includes all documents related to "Biochemistry, beer, spirits, wine, vinegar". It is important to note that this category is also linked to A. "Human Necessities", in the subclass A.23. "Foods or Foodstuffs; Treatment thereof, not covered by other classes", which denotes the great significance of these beverages, and, in general, of the food industry. Some examples include the improvement of vodka mouthfeel and smoothness, the production of distillates such as tequila and pulque with reduced alcohol content, obtaining herring meat of superior quality, increasing the amino acid content of rice, developing pathogen resistant papayas, or elaborating smoked coloured tequila.

Regarding fermented beverages, a patent related to the improvement of these beverages is the patent CN102640957, which describes a product which directly uses a malt extract as a raw material for preparing a fermented beverage and a production method thereof. The beverage has a better flavour, a simpler technology and a lower cost. The beverage is prepared from 1000 g of solid malt extract, 33 g of composite bacterial classification, 28 g of citric acid, 6 g of sodium citrate and 20 g of sodium cyclamate. The production method includes the following steps: a) boiling the solid malt extract with water and hops; b) filtering to obtain an original juice; c) sterilizing the original juice and inoculating the composite bacterial classification to ferment; d) adding silica gel and filtering at a low temperature; e) adding the citric acid, the sodium citrate and the sodium cyclamate to blend; f) inflating, filling and sterilizing to obtain the finished product.

Given the presence of a wide variety of FB available in the market, including beers, wines, kombucha, cider, sake, and their LAFB and NAFB variants, it is expected that producers may need to protect and highlight the qualities of their product, in order to prevent fraud and ensure quality, therefore obtaining the maximum profit possible. In this sense, different approaches are found in the literature, from using genetic biomarkers -to discriminate, for instance, between Ale and Lager yeasts- to the use of analytical chemistry techniques combined with statistical models to study foodstuffs.

However, quality departments and laboratories of most food companies still depend on the analysis of individual parameters, using specific, and usually expensive, equipment, which is not capable of determining complex variables such as geographical location, brand, production batch, etc. For these cases, companies mainly rely on tasting panels, with the inconvenience that these are highly specialised people i.e. trained to recognise either one brand, Designation of Origin, etc. As the trade market is nowadays worldwide, it is likely that issues arise when the product is thousands of kilometres away from where it was produced. The need to take the product back to the tasting panel, or the other way around, can be expensive in both temporal and economic terms. There are further complications regarding these personnel, including the possibility of losing sensory capabilities due to health issues, as happened during the COVID-19 pandemic.

Thus, it is still desired a standardised protocol to identify and classify fermented beverages and derivatives according to complex variables, as well to ensure quality control and fraud detection.

### DESCRIPTION OF THE INVENTION

The proposed method of the present invention of analysis for identifying and classifying fermented beverages (FB) relies on the use of Nuclear Magnetic Resonance (NMR) data, as this technique provides with reproducible qualitative, quantitative, and structural holistic information of compounds present on a complex mixture. The NMR data is then pre-processed using cutting-edge methods, such as local alignment, to be subsequently used for modelling. The results of the model are then translated into a digital fingerprint, which is a novel concept to guarantee transparency to consumers.

It is method of analysis to identify and classify FB and derivatives, including LAFB and NAFB throughout the whole production process, to ensure quality control and fraud detection. The technology proposed for data acquisition is preferably 1D-¹H-NMR, being the most usual NMR experiment performed for metabolomics, since it allows the detection of the whole molecular profile of a complex sample through its ¹H nuclei. In the past, NMR presented limitations related to sensitivity, loss of signals due to high presence of solvent protons, slight shifting between spectra, and, in general, long times for sample optimization, spectra acquisition, and data analysis. However, recent progress has been made in terms of pulse sequence development, to allow solvent signal suppression, as well as in sensitivity, with advances in producing high-field magnets-up to 1.2 GHz-and cryoprobes.

Besides, new programming tools and Artificial Intelligence (AI) algorithms allow automation throughout the whole analysis, from sample preparation and spectra acquisition to data analysis. It is also proposed a processing step that consists of an automated local spectra alignment, used to correct slight chemical-shift deviations that arise from acquiring different samples (i.e. FB of different productions, geographical origin, brands, etc.) and that are critical to ensure subsequent data modelling without bias. Furthermore, to model data and obtain the information for the digital fingerprint, Discriminant Analysis variants of multidimensional supervised models, such as PLS-DA, are proposed for FB for the first time.

In particular, the digital fingerprint developed only relies on NMR data being translation of the complex information of the model, into a code accessible and understandable for the general public and consumers.

Overall, the advances in ¹H-NMR, technology that allows the detection of the whole proton composition on a sample, in conjunction with automation innovations in both processing and modelling steps, allow us to propose an invention to identify and classify FB and derivatives respect complex variables: brand, production batch that account for seasonal or annual differences, geographical location, etc.

The mentioned dataset may consist preferably of a balanced number of each sample for every class. The number of samples will depend on various aspects, including the size of the effect, meaning if differences between groups are evident, or not. For instance, differences between a black beer, and a lager beer, are expected to be greater than differences between brands of a lager beer, and therefore it is likely that more samples are required to discriminate between brands of lager beers. For this reason, is recommendable to perform pilot data to test the statistical power of the design. Furthermore, it is relevant to consider that, to ensure good generalization of the model, at least, two independent set of samples could be used, in which 2/3 of the dataset will be used for model training, and the 1/3 left, for model testing.

The mentioned sample preparation may present slight variations depending on the matrix to analyse. For instance, carbonated beverages may include a degassing step. Also, a generally common step between samples is lyophilization, given that most beverages are mainly composed of water. However, lyophilization time may vary as well between 16-48 hours depending on the composition of the sample, or the load charged into the bottle of the freeze-dryer. After lyophilization, the freeze-dried material may be resuspended in a standardization buffer. Again, the composition of such buffer is dependent on the properties of the product, such as the range of pH of samples to be compared. Nonetheless, in some embodiments, the standardization buffer includes D₂O, to adjust the lock on the NMR spectrometer, and 3-(TrimethylSilyl) Propionic-2,2,3,3-d4 acid (TSP), a reference compound for compound identification and quantification. After resuspending the material, samples could be centrifuged, and the supernatant could be loaded into 5 mm NMR tubes, to avoid turbidity and precipitation caused by macromolecules.

Spectra processing could include chemical-shift referencing, phasing, and baseline correction, to be performed automatically after sample acquisition, and before the automated local spectra alignment. Besides, scaling spectra with respect to a known stable signal is helpful to compare intensities.

Regarding Nuclear Magnetic Resonance experiments, the pulse sequence used for profiling may be a 1D-¹H-Nuclear Overhauser Effect SpectroscopY (1D-¹H-NOESY) experiment with presaturation to suppress residual water (d1) and spoil gradients. Among the NMR spectrometers, different magnetic fields are available to perform the experiments, depending on the sensitivity, resolution, etc. needed to distinguish between samples. Regardless of this, parameter optimization is required, more specifically, the length of the pulse, and the frequency of the presaturation pulse. After parameter optimization using one sample, it could be used an autosampler to run batches in automation mode, to ensure reproducibility.

For data processing, local spectra alignment, peak detection, and peak selection could be performed. After exporting the spectra, the chemical-shift axes can slightly differ between samples. However, the method proposed for data processing requires one same chemical-shift axis for the different spectra intensities. To avoid data interference, it is advisable to check the maximum displacement between the chemical shifts of every sample. Only if such displacement is considerably smaller than the chemical-shifts' intervals used for spectra alignment and peak detection/selection, the axis of any sample can represent the rest. If this condition does not apply, further steps for data interpolation should be included, for instance, performing zero-filling, or fitting spectra to linear equations to obtain new data points. The result of the local alignment is a matrix containing the chemical shifts and intensities of peaks among samples. Subsequent data transformation, such as normalization and/or centring, is recommended.

Regarding the Modelling of Nuclear Magnetic Resonance data, Discriminant Analysis variants of Multidimensional Supervised approaches are recommended. In these cases, first, the optimum number of components to include the whole variability between classes should be tuned. To do so, a wide variety of cross-validation methods and distances are available. To select the most appropriate number of components to include in the model, it is relevant to try to minimize the error rates per class. Besides, there are also versions of algorithms that allow not only selection of components, but also to tune the number of variables to include for the calculation of every component. In that case, variable tuning can be performed as well using cross-validation methods. Independently on the model, a common step is its evaluation using the test dataset, in order to quantify the performance of the model.

The mentioned digital fingerprint is a translation of the model into an accessible code. To generate it, representative coordinates of every class are weighted from 0 to 100. Afterwards, a colour gradient is assigned to every component, in a manner that a reference colour code could be generated for each class of the mode. In other words, a reference digital fingerprint of each class is obtained. This is useful to visually identify a sample by its digital fingerprint, since its NMR spectra can be run through the model, and afterwards, its obtained coordinates are transformed according to the gradient established. A simple visual inspection of the digital fingerprint of a test sample compared to the reference fingerprints for the classes allows identification of the sample.

More particularly, the method of analysis for identifying and classifying fermented beverages, comprises the steps of i) preparing at least two independent samples of the fermented beverages; ii) performing data acquisition with a Nuclear Magnetic Resonance spectrometer over samples; iii) performing data processing over the Nuclear Magnetic Resonance data of samples comprising an automated local spectra alignment, performed to correct chemical shift deviations between samples, as well as further scaling, centring, or normalization steps; and data modelling performed by using Discriminant Analysis variants of multidimensional supervised model for determining a class of every sample; iv) generating a digital fingerprint based on the classes determined, optionally, generating a digital fingerprint based on the representative coordinates values obtained from the model for each of the classes determined, and also optionally, translating it into an accessible code using a colour gradient. In this way, it is guaranteed transparency to consumers in the process of identifying and classifying fermented beverages, and it also is ensured a quality control and fraud detection in said process.

In addition, the step i) comprises a degassing step in the case of carbonated beverages, to ensure precise volume pipetting.

Furthermore, the step i) comprises a lyophilization step, to increase the concentration of the sample, and thus being able to detect compounds found in small concentration.

More specifically, the step i) is a resuspension step in a standardization buffer, to match the pH values of samples (chemical shifts are pH sensitive), as well as to include an internal reference for compound identification and quantification.

Optionally, the standardization buffer includes D₂O and 3-(TrimethylSilyl) Propionic-2,2,3,3-d4 acid (TSP). The D₂O helps to adjust the lock on the NMR spectrometer. And the 3-(TrimethylSilyl) Propionic-2,2,3,3-d4 acid (TSP), sets a reference compound for compound identification and quantification.

According to another aspect of the invention, the step i) of preparing at least two independent samples of each class of the fermented beverages comprises a centrifugation of the sample, to avoid turbidity and precipitation caused by macromolecules.

Preferably, the step ii) is performed via 1D-¹H-NMR technology, since it allows the detection of the whole molecular profile of a complex sample through its ¹H nuclei.

According to a preferred embodiment of the invention, the pulse sequence used for profiling is a 1D-¹H-Nuclear Overhauser Effect SpectroscopY (1D-¹H-NOESY) experiment with presaturation, in order to suppress residual water and spoil gradients.

Complementarily, the step ii) further comprises performing a parameter optimization over at least one sample, including: the length and power of the pulse, to make sure that all the protons of the sample are excited; the length of the relaxation delay, to give enough time to all protons to relax before applying another excitation pulse; and/or the frequency and power of the presaturation pulse, to successfully diminish the solvent signal. To optimize these parameters, experiments are acquired trying different values. Final parameter selection is based on signal to noise ratio, and solvent suppression.

Optionally, after the parameter optimization, the method comprises the step of running batches in automation mode using an autosampler, in order to ensure reproducibility.

More in detail, the step iii) comprises local spectra alignment, which consists in correcting chemical shift deviations between spectra; peak detection, to distinguish noise from spectral information; and/or peak selection, for instance, if only specific signals found in all, or some spectra wanted to be study, rather than the whole profile. Peaks detected and selected will be used as predictor variables in subsequent modelling.

Furthermore, the step iii) comprises data normalization, which consists in adjusting the data values to a normal distribution, and/or data mean centring subtracting the mean to every data value. It also includes modelling via Discriminant Analysis variants of multidimensional supervised models such as PLS-DA. In this way, the digital fingerprint developed in this work only relies on NMR data, in contrast to previous methods found in the literature that represent an abstraction of the combination of different data, and thus depend on the acquisition and integration of different datasets, hindering its application in the industry.

Complementarily, the data modelling comprises building Partial Least Squares-Discriminant Analysis (PLS-DA) model using the training dataset of samples and previously defined labels for fermented beverage class. Subsequent evaluation using the test dataset allows to quantify the performance of the model.

In a preferred embodiment of the invention, the digital fingerprint is a colour gradient assigned to every class of the data modelling. Therefore, a reference digital fingerprint of each class is obtained.

Additionally, the method of analysis for identifying and classifying fermented beverages, further comprises the step of performing spectra processing over the fermented beverage sample, i.e. performing chemical-shift referencing, by setting the reference compound chemical shift to 0; phasing the signals to positive values, by calculating the phase angles needed to put the real and imaginary spectra in absorption and dispersion mode, respectively; and/or baseline correction, by fitting the baseline to a polynomial function to obtain a flat baseline. This step allows for reliable compound identification and quantification.

In the attached drawings it is shown, by way of non-limiting example, a method of analysis for identifying and classifying fermented beverages, constituted according to the invention. Other characteristics and advantages of said method of analysis for identifying and classifying fermented beverages, object of the present invention will become apparent from the description of a preferred, but not exclusive, embodiment that is illustrated by way of non-limiting example in the accompanying drawings, in which:

### BRIEF DESCRIPTION OF THE DRAWINGS

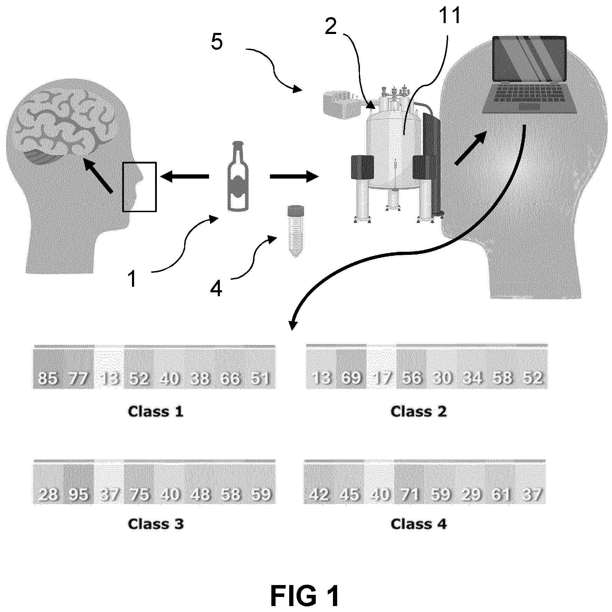

Figure 1.- Is a comparison of traditional tasting panels with the method proposed, including a Nuclear Magnetic Resonance spectrometer, a computer for analysis, and the digital fingerprint as a result, in accordance with the present invention.

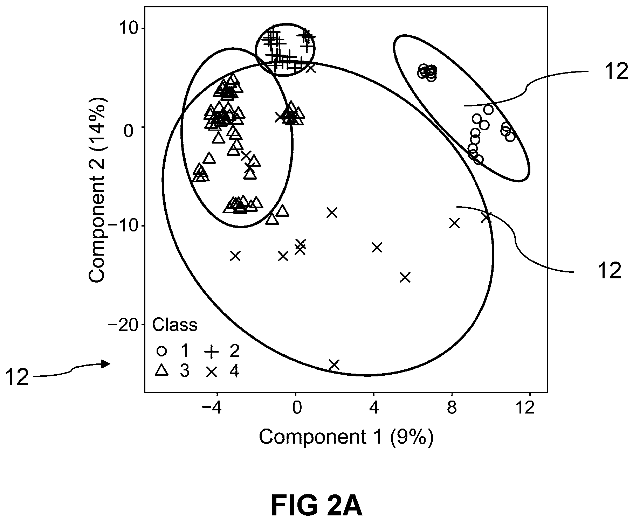

Figure 2A.- Is view of graphical representation of the train samples on components 1 and 2 from the sparse PLS-DA model built. Samples from the train dataset are represented in dots of different shapes according to the classes established for each brand of beer (class 1: circles;
class 2: plus symbol; class 3: triangle; class 4: cross). Using these components, only samples from the brand and class 1 can be completely separated from the rest. This shows the importance of multidimensional models, in accordance with the present invention.

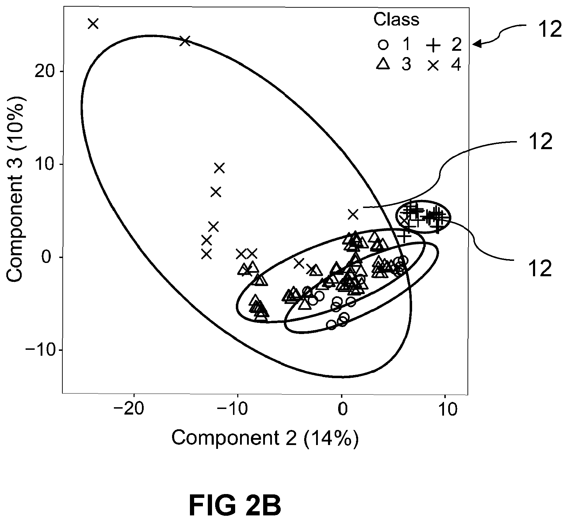

Figure 2B.- Is view of a graphical representation of the train samples on components 2 and 3 from the sparse PLS-DA model built. Samples from the train dataset are represented in dots of different shapes according to the classes established for each brand of beer, following the same code as in Figure 2A. Using these components, only samples from the brand and class 2 can be completely separated from the rest. This shows the importance of multidimensional models, in accordance with the present invention.

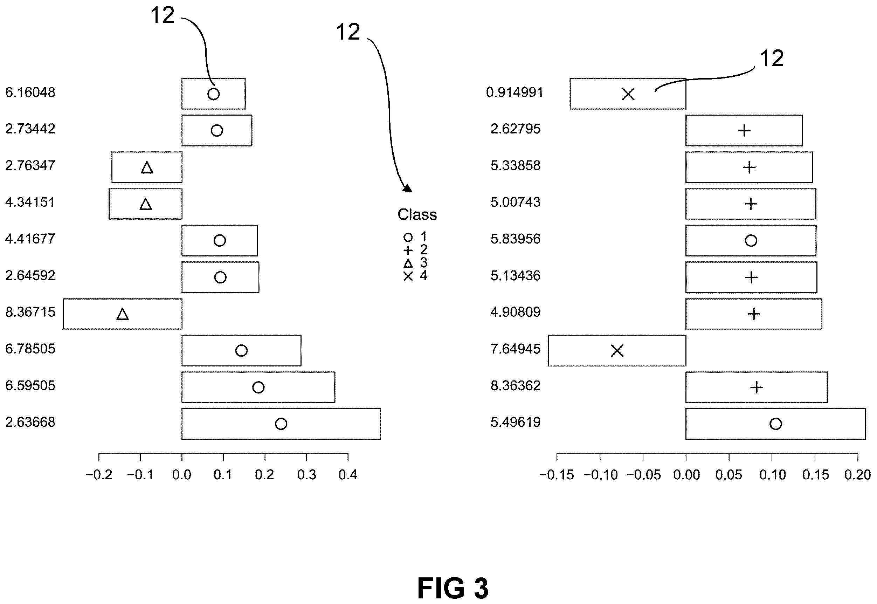

Figure 3.- Is view of the contribution of the 10 most relevant chemical shifts in component 1 (left) and 2 (right) to discriminate between the different classes established for each brand of beer. The length of the bars represents the weight (a.u.) of the chemical shift, and the style of the dots plotted in the centre, the class in which such signal is more present. The dot style code is identical to that from Figures 2A and 2B, in accordance with the present invention.

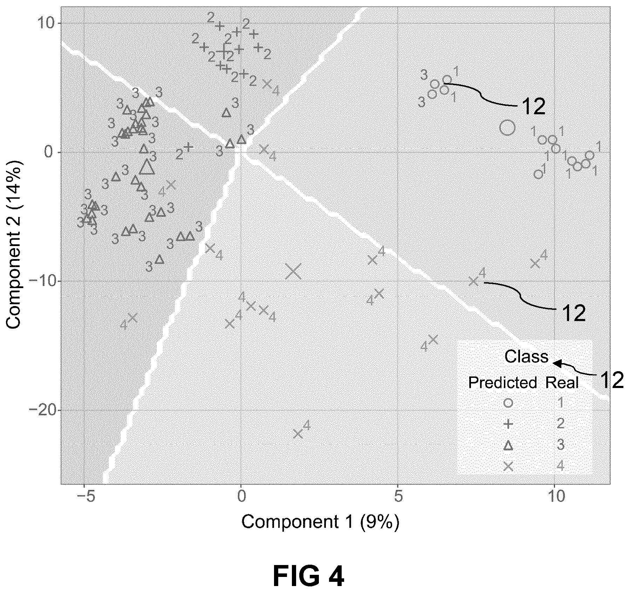

Figure 4.- Is view of a graphical representation of the prediction background of the sparse PLS built for components 1 and 2. Centroids of the prediction area of each class are shown as dots of larger size compared the prediction of the test samples. Different shapes of dots are used for every predicted class, following the same code from previous figures. The real class is shown as a label located right next to the correspondent dot. As can be seen in the plot, only two samples from the brand and class 3 are mistakenly predicted as class 1. As 66 samples out of the 68 were correctly predicted, the model reached an accuracy of 97%, in accordance with the present invention.

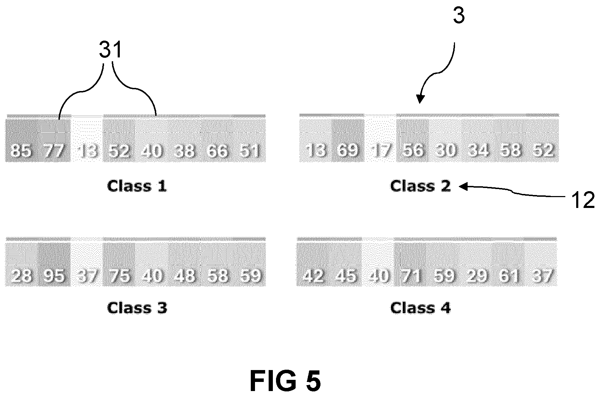

Figure 5.- Is view of a representation of the reference digital fingerprints for the classes modelled. These digital fingerprints are a simple representation of built model, to make it accessible to the general public and consumers. For each class, the numbers and coloured squares represent the value of the coordinate for the centroid, and its correspondence in a colour gradient. The thinner line above represents the maximum of each colour gradient, i.e. the maximum weighted value of 100. Including both the number and colour gradient permits higher accessibility of the digital fingerprint, in accordance with the present invention.

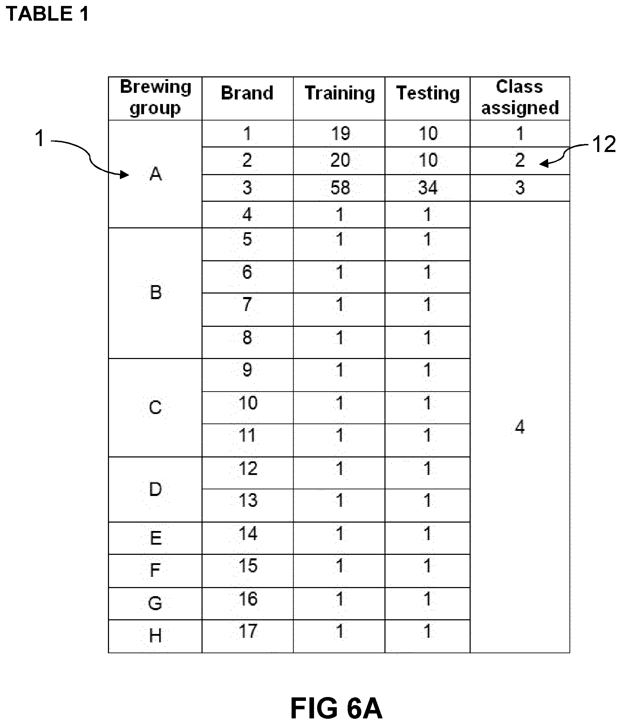

Figure 6A.- Is view of the Table 1 with train and test datasets, in accordance with the present invention.

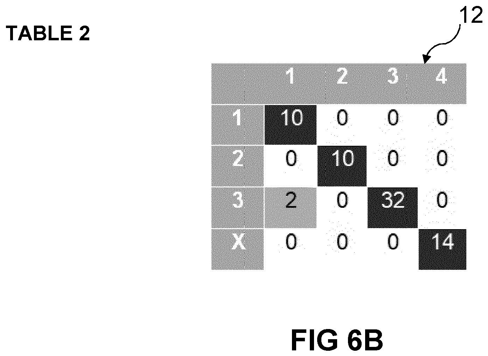

Figure 6B.- Is view of the Table 2, with a confusion matrix of test samples. By columns, prediction of the test dataset. By rows, real classes of the test dataset, in accordance with the present invention.

### DESCRIPTION OF A PREFERRED EMBODIMENT

In view of the aforementioned figures and, according to the numbering adopted, a preferred embodiment of the invention can be seen in them, which comprises the parts and elements indicated and described in detail below.

The dataset used for the example consisted of 179 lager beers from different brands and brewing groups, being 111 used for model training, and 68 for model testing. More specifically, beers belonged to groups A, B, C, D, E, F, G, and H. In Table 1, the brewing groups, brands and number of samples used to train and test the model are shown according to the class assigned. It is important to note that samples between classes are balanced, being around 30 samples, of which 2/3 were used for training, and 1/3 for testing. However, the number of samples from class 3 triplicates the other three. This is because for this class, samples from three different geographical locations could be included in the study.

Regarding the sample preparation, fresh samples (small bottles and/or cans) were opened, and beer was immediately poured into 30 mL dark glass bottles for subsequent degassing in an ultrasound bath for 20 min at room temperature. Afterwards, 5 mL of beer of each beer was pipetted into plastic tubes, and frozen at -80 °C prior to lyophilization. When samples were frozen, lyophilization was performed for 24 h approximately. After lyophilization, the freeze-dried material was resuspended on 600 µL of a standardization buffer with the following composition: 400 µL of 99.9% D₂O, 140 µL of 400 mM oxalate buffer pH 4.0, and 60 µL of 5 mM 97% 3-(TrimethylSilyl) Propionic-2,2,3,3-d4 acid (TSP). Finally, tubes were centrifuged 10 min at 6000 g, and 600 µL of the supernatants were loaded into 5 mm NMR tubes.

The Nuclear Magnetic Resonance spectra of every beer sample was using an AV NEO 500 MHz spectrometer with an autosampler. The pulse sequence used was 1D-¹H-Nuclear Overhauser Effect SpectroscopY (1D-¹H-NOESY) with presaturation to suppress residual water (d1) and spoil gradients. After parameter optimization using one sample, samples were run in automation mode, and the final experimental time per sample was ca. 49 min, using a pulse between 12-14 µs, and setting the presaturation pulse in the centre of the water signal, usually around 2348-2350 Hz. Considering that the maximum capacity of the autosampler was of 60, samples were prepared, and experiments run, in different batches of around 60 samples.

Regarding spectra processing, including chemical-shift referencing, phasing, and baseline correction, were also automatically performed after sample acquisition. To scale the spectra, the intensities of TSP were used. Specifically, spectra were scaled in a way that the TSP peak highest point value was adjusted to 1000 for every spectrum.

For data processing, first, local spectra alignment, peak detection, and peak selection were performed. To avoid data interference due to variations between the chemical shift axis, the maximum displacement between chemical shifts was calculated, and it was checked that such displacement was negligible compared to the chemical-shifts' intervals used for spectra alignment and peak detection/selection. Therefore, the chemical-shifts axis of the first sample from the first batch was used as axis of the whole dataset. Afterwards, the resulting matrix of the alignment was normalized and centred.

Regarding Modelling of Nuclear Magnetic Resonance data, a Partial Least Squares-Discriminant Analysis (PLS-DA) first model of 15 components was built using the data matrix of the training dataset and the previously defined labels for classes (1, 2, 3, 4). The model was tuned using internal M-fold cross-validation method (folds = 5) for Maximum, Centroids and Mahalanobis distances. Among the different distances and number of components to include in the model, the one that minimized the global and per class error rates from the cross-validation was chosen (i.e. a Maximum distance model with 11 components). Once the number of components and distance to build the model were chosen, a sparse version of PLS-DA model was built to tune the number of variables (chemical shifts) to include in each component. To do so, the model was cross-validated using internal M-fold cross-validation method (folds = 5) and Maximum distance. For each component, the number of chemical shifts that minimized the error rates were, respectively, 4, 420, 230, 820, 1, 250, 780, 3, 30, 530, and 240. Finally, the model was evaluated through the prediction of the test dataset, with the subsequent calculation of accuracy based on the confusion matrix (Table 2).

In this example, to translate the model to its digital fingerprints, the coordinates of the centroid of each component and class of the model were used. More precisely, its values were weighted between 0 and 100, and, as described above, a colour gradient was assigned to each component. A simple visual inspection of the digital fingerprint of a test sample compared to the reference fingerprints for the classes allows identification of the sample. In Figure 5, an example for the digital fingerprints for each class of the built model is shown, and differences amongst classes can be perceived with just a glance.

More particularly, the method of analysis for identifying and classifying fermented beverages (1), comprises the steps of: i) preparing at least two independent samples (11) of the fermented beverages (1); ii) performing data acquisition with a Nuclear Magnetic Resonance spectrometer (2) over samples (11); iii) performing data processing over the Nuclear Magnetic Resonance data of samples (11) comprising: an automated local spectra alignment, performed to correct chemical shift deviations between samples (11); and data modelling performed by using Discriminant Analysis variants of multidimensional supervised model for determining a class (12) of every sample (11); iv) generating a digital fingerprint (3) based on the classes (12) determined;

Preferably the method comprises a previous step of establishing a dataset of samples (11) for every fermented beverage (1) class (12). To ensure good generalization of the model, at least, two independent set of samples should be used, in which 2/3 of the dataset will be used for model training, and the 1/3 left, for model testing.

Optionally, the step i) of the method comprises a degassing step in the case of carbonated beverages.

Additionally, the step i) of the method comprises a lyophilization step.

Advantageously, the step i) of the method is a resuspension step in a standardization buffer (4).

According to another aspect of the invention, the standardization buffer (4) includes D₂O and 3-(TrimethylSilyl) Propionic-2,2,3,3-d4 acid (TSP).

In a preferred embodiment of the invention, the step i) of preparing at least two independent samples (11) of each class (12) of the fermented beverages (1) comprises a centrifugation of each sample (11). The supernatant is loaded into 5 mm NMR tubes, to avoid turbidity and precipitation caused by macromolecules.

Preferably, the step ii) of the method is performed via 1D-¹H-NMR technology.

Optionally, the pulse sequence used for profiling is a 1D-¹H-Nuclear Overhauser Effect SpectroscopY (1D-¹H-NOESY) experiment with presaturation.

More specifically, the step ii) of the method further comprises performing a parameter optimization over at least one sample (11), including the length and power of the pulse and/or the frequency and power of the presaturation pulse.

Complementarily, the method of analysis for identifying and classifying fermented beverages further comprises, after the parameter optimization, running batches in automation mode using an autosampler (5).

In addition, the step iii) of the method comprises local spectra alignment, peak detection and/or peak selection.

Furthermore, the step iii) of the method comprises data normalization and/or data centring.

According to a preferred embodiment of the invention, the data modelling comprises building Partial Least Squares-Discriminant Analysis (PLS-DA) model using the training dataset of samples (11) and previously defined labels for fermented beverage (1) class (12).

According to another aspect of the invention, the digital fingerprint (3) is a colour gradient (31) assigned to every class (12) of the data modelling.

Additionally, the method of analysis for identifying and classifying fermented beverages (1) further comprises the step of performing spectra processing over the fermented beverage (1) sample (11). This is achieved by performing chemical-shift referencing, phasing the signals to align the real and imaginary spectra in absorption and dispersion mode, respectively, and correcting the baseline by fitting it to a polynomial function to obtain a flat profile. Said spectra processing comprises chemical-shift referencing, phasing and/or baseline correction.

### List of numerical references:

- 1: fermented beverage
- 11: sample
- 12: class
- 2: Nuclear Magnetic Resonance spectrometer
- 3: digital fingerprint
- 31: colour gradient
- 4: standardization buffer
- 5: autosampler

### List of abbreviations:

- FB: fermented beverages
- LAFB: Low-Alcoholic Fermented Beverages
- NAFB: Non-Alcoholic Fermented Beverages
- NMR: Nuclear Magnetic Resonance
- IR: Infrared Spectroscopy
- MS: Mass Spectrometry
- D₂O: heavy water

## Claims

1. Method of analysis for identifying and classifying fermented beverages (1), comprising the steps of:
i) preparing at least two independent samples (11) of the fermented beverages (1);
ii) performing data acquisition with a Nuclear Magnetic Resonance spectrometer (2) over samples (11);
iii) performing data processing over the Nuclear Magnetic Resonance data of samples (11) comprising:
• an automated local spectra alignment, performed to correct chemical shift deviations between samples (11); and
• data modelling performed by using a Discriminant Analysis variants of multidimensional supervised model for determining a class (12) for every sample (11);
iv) generating a digital fingerprint (3) based on the classes (12) determined.

2. Method of analysis for identifying and classifying fermented beverages (1), according to claim 1, wherein the step i) comprises a degassing step in the case of carbonated beverages, a lyophilization step and/or a resuspension step in a standardization buffer (4).

3. Method of analysis for identifying and classifying fermented beverages (1), according to claim 2, wherein the step i) comprises the a resuspension step and the standardization buffer (4) includes D₂O and 3-(TrimethylSilyl) Propionic-2,2,3,3-d4 acid (TSP).

4. Method of analysis for identifying and classifying fermented beverages (1), according to claims 1 to 3, wherein the data modelling step comprises a stage of defining an optimum number of components between classes by using cross-validation methods and distances and minimizing the error rates per class.

5. Method of analysis for identifying and classifying fermented beverages (1), according to claim 4, wherein the data modelling step further comprises a stage of defining a number of variables to include for the calculation of every component by using cross-validation methods.

6. Method of analysis for identifying and classifying fermented beverages (1), according to any of the claims 1 to 5, wherein the step i) of preparing at least two independent samples (11) of the fermented beverages (1) comprises a centrifugation of the sample (11).

7. Method of analysis for identifying and classifying fermented beverages (1), according to claim 1, further comprising the step, previous to the automated local spectra alignment, of performing spectra processing over the fermented beverage (1) sample (11) by performing chemical-shift referencing, by setting a reference compound chemical shift to 0, phasing the signals to positive values, by calculating the phase angles needed to put the real and imaginary spectra in absorption and dispersion mode, respectively, and/or baseline correction, by fitting the baseline to a polynomial function to obtain a flat baseline.

8. Method of analysis for identifying and classifying fermented beverages (1), according to claim 7, wherein the step of performing data acquisition is performed via 1D-¹H-NMR technology.

9. Method of analysis for identifying and classifying fermented beverages (1), according to claim 8, wherein the pulse sequence used for profiling is a 1D-¹H-Nuclear Overhauser Effect SpectroscopY (1D-¹H-NOESY) experiment with presaturation.

10. Method of analysis for identifying and classifying fermented beverages (1), according to any of the claims 1 to 9, wherein the step ii) further comprises performing a parameter optimization over at least one sample (11), including optimizing a length and power of the pulse, by ensuring that all the protons of the sample are excited, a length of a relaxation delay, by waiting a predefined time before applying next excitation pulse to let all protons to relax, and/or a frequency and power of the presaturation pulse.

11. Method of analysis for identifying and classifying fermented beverages (1), according to claim 10, wherein the step iii) further comprises peak detection, by differencing noise from spectral information, and/or peak selection, for determining a selected spectra to be analzed.

12. Method of analysis for identifying and classifying fermented beverages (1), according to any of the claims 1 to 11, wherein the local spectra alignment, determines a common axis for the samples by:
• if a maximum displacement between chemical shifts of every sample is smaller than chemical-shifts' intervals used, the axis of one of the samples is selected; and
• if the maximum displacement between chemical shifts of every sample is greater than chemical-shifts' intervals used, data interpolation is performed to determine a common axis for the samples.

13. Method of analysis for identifying and classifying fermented beverages (1), according to claim 12, wherein the step iii) further comprises data normalization, by adjusting the data values to a normal distribution, and/or data mean centring, subtracting a mean to each data value, after the automated local spectra alignment.

14. Method of analysis for identifying and classifying fermented beverages (1), according to claim 13, wherein the data modelling comprises building Partial Least Squares-Discriminant Analysis (PLS-DA) model using training dataset of samples (11) and previously defined labels for fermented beverage (1) class (12).

15. Method of analysis for identifying and classifying fermented beverages (1), according to claim 14, wherein the digital fingerprint (3) is a colour gradient (31) assigned to every class (12) of the data modelling.
